(19) Europäisches Patentamt / European Patent Office / Office européen des brevets

(11) **EP 4 279 640 A1**

(12) **EUROPEAN PATENT APPLICATION**
published in accordance with Art. 153(4) EPC

(43) Date of publication:
**22.11.2023 Bulletin 2023/47**

(21) Application number: **21919629.2**

(22) Date of filing: **09.12.2021**

(51) International Patent Classification (IPC):
**C25D 3/60** (2006.01)

(52) Cooperative Patent Classification (CPC):
**C25D 3/60**

(86) International application number:
**PCT/JP2021/045355**

(87) International publication number:
**WO 2022/153740 (21.07.2022 Gazette 2022/29)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **13.01.2021  JP 2021003148**

(71) Applicant: **Mitsubishi Materials Corporation
Tokyo 100-8117 (JP)**

(72) Inventor: **TATSUMI, Koji
Sanda-shi, Hyogo 669-1339 (JP)**

(74) Representative: **Gille Hrabal
Partnerschaftsgesellschaft mbB
Patentanwälte
Brucknerstraße 20
40593 Düsseldorf (DE)**

(54) **TIN ALLOY PLATING SOLUTION**

(57)  A tin alloy plating solution of the present invention includes (A) a soluble salt or oxide including at least a stannous salt, (B) a soluble salt of a metal nobler than tin, (C) a tin complexing agent formed of a sugar alcohol having 4 or more and 6 or less carbon atoms, (D) a free acid, and (E) an antioxidant. In addition, a content of the tin complexing agent is 0.1 g/L or more and 5 g/L or less, and a concentration of divalent tin ions ($Sn^{2+}$) is 30 g/L or more.

EP 4 279 640 A1

**Description**

[Technical Field]

The present invention relates to a tin alloy plating solution for manufacturing bumps which are to be tin alloy protruding electrodes on a substrate when mounting a semiconductor integrated circuit chip on a circuit substrate.
Priority is claimed on Japanese Patent Application No. 2021-003148, filed January 13, 2021, the content of which is incorporated herein by reference.

[Background Art]

In the related art, non-cyanide Au-Sn alloy plating solutions containing a non-cyanide soluble gold salt, a Sn compound formed of tetravalent Sn, and thiomonocarboxylic acid, which is a thiocarboxylic acid compound, are disclosed (for example, refer to Patent Document 1 (claims 1-3, paragraph [0017], and paragraph [0024])). This non-cyanide Au-Sn alloy plating solution further includes sugar alcohols, in which the sugar alcohols are D-(-)sorbitol or xylitol. In addition, the concentration of the Sn compound formed of a soluble gold salt and tetravalent Sn is set according to the desired Au-Sn alloy ratio and the like, but is preferably 1 to 10 g/L as Au metal and 1 to 20 g/L as Sn metal. When the metal concentration is excessively low, there are problems such as being unable to obtain sufficient deposition efficiency, while when the concentration is excessively high, problems such as poor liquid stability may easily occur.
Patent Document 1 indicates that the non-cyanide Au-Sn alloy plating solution formed in this manner makes it possible to reduce the environmental impact and does not cause a decrease in liquid stability, such as the generation of precipitation due to oxidation of the Sn compound, and thus it is possible to efficiently apply an Au-Sn alloy plating to plating objects such as semiconductor wafers.

[Citation List]

[Patent Document]

[Patent Document 1]

Japanese Patent (Granted) Publication No. 6207655 (B)

[Summary of Invention]

[Technical Problem]

However, in the non-cyanide Au-Sn alloy plating solution shown in Patent Document 1 described above, even if the concentration as Sn metal was within the range of 1 to 20 g/L, the $Sn^{4+}$ concentration was still high at the upper limit value of this range and thus there were problems in that $SnO_2$ sludge was generated in the plating solution when stored for a long period, the metal ions (Au ions, Ag ions, and Cu ions), which are more noble than the Sn ions in the plating solution, were substituted and deposited on the sludge, and the concentration of Au ions, Ag ions, and Cu ions in the plating solution decreased.
An object of the present invention is to provide a tin alloy plating solution in which $SnO_2$ sludge is not easily generated in the plating solution even when stored for a long period and it is possible to stabilize the concentration of Ag ions or Cu ions by suppressing a decrease in the concentration of Ag ions or Cu ions in the plating solution.

[Solution to Problem]

A tin alloy plating solution (referred to below as the "tin alloy plating solution of the present invention") of one aspect of the present invention includes (A) a soluble salt or oxide including at least a stannous salt, (B) a soluble salt or oxide of a metal nobler than tin, (C) a tin complexing agent formed of a sugar alcohol having 4 or more and 6 or less carbon atoms, (D) a free acid, and (E) an antioxidant, in which a content of the tin complexing agent is 0.1 g/L or more and 5 g/L or less, and a concentration of divalent tin ions ($Sn^{2+}$) is 30 g/L or more.
The aspect described above may have a pH of 3 or less.
In the aspect described above, the metal nobler than tin may be silver or copper.
In the aspect described above, a concentration of tetravalent tin ions ($Sn^{4+}$) may be 5 g/L or less immediately after a plating bath or after storage for 6 months at 40°C in a light-shielded container under tightly sealed conditions.

[Advantageous Effects of Invention]

The tin alloy plating solution of the present invention includes (A) a soluble salt or oxide including at least a stannous salt, (B) a soluble salt or oxide of a metal nobler than tin, (C) a tin complexing agent formed of a sugar alcohol having 4 or more and 6 or less carbon atoms, (D) a free acid, and (E) an antioxidant, in which a content of the tin complexing agent is 0.1 g/L or more and 5 g/L or less, and a concentration of divalent tin ions ($Sn^{2+}$) is 30 g/L or more, thus, the sugar alcohol having 4 or more and 6 or less carbon atoms acts together with the antioxidant in the presence of the free acid to make it possible to strongly stabilize the divalent tin ions ($Sn^{2+}$). As a result, $SnO_2$ sludge is not easily generated in the plating solution even when stored for a long period and it is possible to stabilize the concentration of Ag ions or Cu ions by suppressing a decrease in the concentration of Ag ions or Cu ions in the plating solution.

When the pH of the tin alloy plating solution is 3 or less, it is possible to increase the plating speed by increasing the current density to 2 ASD or more. In the non-cyanide Au-Sn alloy plating solution shown in Patent Document 1, the pH is in the neutral range and thus there is a problem in that use is only possible at low range plating speeds at a current density of 1 ASD or less and productivity is poor.

When the metal nobler than tin is silver or copper, solder wettability, mounting strength, bendability, and reflowing property are excellent and there are effects such as that whiskers are not easily generated and, when a semiconductor integrated circuit chip is mounted on a circuit substrate, it is possible to efficiently manufacture bumps which are to be protruding electrodes of tin-silver or tin-copper on the substrate.

When the concentration of tetravalent tin ions ($Sn^{4+}$) is 5 g/L or less immediately after a plating bath or after storage for 6 months at 40°C in a light-shielded container under tightly sealed conditions, $SnO_2$ sludge is not easily generated in the plating solution even when stored for a long period due to the low tetravalent tin ion ($Sn^{4+}$) concentration. As a result, metal ions (Ag ions and Cu ions) nobler than Sn ions in the plating solution are not substituted and deposited on the sludge of $SnO_2$ and the concentration of Ag ions and Cu ions in the plating solution does not decrease.

[Description of Embodiments]

Next, a description will be given of an embodiment for carrying out the present invention. The tin alloy plating solution of the present invention includes (A) a soluble salt or oxide including at least a stannous salt, (B) a soluble salt or oxide of a metal nobler than tin, (C) a tin complexing agent formed of a sugar alcohol having 4 or more and 6 or less carbon atoms, (D) a free acid, and (E) an antioxidant.

[Tin Alloy]

The tin alloy made from the tin alloy plating solution of the present embodiment is an alloy of tin (Sn) and a predetermined metal selected from silver (Ag), copper (Cu), gold (Au), and bismuth (Bi) and examples thereof include binary alloys such as SnAg alloys, SnCu alloys, SnAu alloys, and SnBi alloys and ternary alloys such as SnCuAg alloys.

[Soluble Salt or Oxide (A) including at least Stannous Salt]

The soluble salt or oxide (A) including at least a stannous salt (simply referred to below as a soluble salt including a stannous salt) used in the tin alloy plating solution of the present embodiment is a salt that dissolves in water to produce divalent tin ions ($Sn^{2+}$). Examples of soluble salts include halides, sulfates, oxides, alkane sulfonic acid salts, aryl sulfonic acid salts, and alkanol sulfonic acid salts. Specific examples of alkane sulfonic acid salts include methane sulfonic acid salts and ethane sulfonic acid salts. Specific examples of aryl sulfonic acid salts include benzene sulfonic acid salts, phenol sulfonic acid salts, cresol sulfonic acid salts, and toluene sulfonic acid salts.

Specific examples of alkanol sulfonic acid salts include isethionate salts.

In addition, the concentration of divalent tin ions ($Sn^{2+}$) in the tin alloy plating solution of the present embodiment is 30 g/L or more and preferably 40 g/L or more. Furthermore, in the present embodiment, immediately after a plating bath or after storage for 6 months at 40°C in a light-shielded container under tightly sealed conditions, the tetravalent tin ion ($Sn^{4+}$) concentration in the tin alloy plating solution is preferably 5 g/L or less and more preferably 2 g/L or less. Here, the reason for limiting the concentration of divalent tin ions ($Sn^{2+}$) to 30 g/L or more is that, at less than 30 g/L, there are problems such as poor uniform electrodepositivity during high-speed plating at a current density of 2 ASD or higher. In addition, the reason for limiting the concentration of the tetravalent tin ions ($Sn^{4+}$) to 5 g/L or less is that, when the concentration is over 5 g/L, $SnO_2$ sludge is easily generated in the plating solution in a case of being stored for a long period and metal ions (Ag ions and Cu ions) nobler than Sn ions in the plating solution are substituted and deposited on the $SnO_2$ sludge and the concentration of Ag ions and Cu ions in the plating solution decreases.

The upper limit value of the concentration of divalent tin ions ($Sn^{2+}$) may be 100 g/L.

The lower limit value of the concentration of tetravalent tin ions ($Sn^{4+}$) may be 0.1 g/L immediately after a plating bath or after storage for 6 months at 40°C in a light-shielded container under tightly sealed conditions.

The soluble salt (A) including at least a stannous salt (referred to below as soluble tin salt (A)) may be used alone or a combination of two or more may be used. The content of the soluble tin salt (A) in the tin alloy plating solution of the present embodiment is preferably in the range of 5 g/L or more and 200 g/L or less and more preferably in the range of 20 g/L or more and 100 g/L or less in terms of the amount of tin. In a case where the content of the soluble tin salt (A) is excessively low, tin deposition normally becomes difficult in a range of a current density of 1 ASD or more and 20 ASD or less (ASD: amperes per square decimeter) typically used in bump plating and there is a concern that it may become impossible to form good bumps. On the other hand, in a case where the content of the soluble tin salt (A) is excessively high, the viscosity of the plating solution increases, making it difficult to form bumps and there is a concern that the cost of the plating bath will increase since more tin is included than necessary.

[Soluble Salt or Oxide (B) of Metal nobler than Tin]

The soluble salt or oxide (B) of a metal nobler than tin (simply referred to below as a soluble salt of a metal nobler than tin) used in the tin alloy plating solution of the present embodiment is a salt that dissolves in water. Examples of metals nobler than tin include at least one or two or more metals selected from silver, copper, gold, and bismuth. Examples of these soluble salts (B) of metals nobler than tin are the same as the examples of the soluble tin salts (A). Among these metals, it is preferable to include silver or copper. This is because the solder wettability, mounting strength, bendability, and reflowing property are excellent and there are effects such as that whiskers are not easily generated and, when a semiconductor integrated circuit chip is mounted on a circuit substrate, it is possible to efficiently manufacture bumps which are to be protruding electrodes of tin-silver or tin-copper on the substrate. An alloy of tin and silver (SnAg alloy) has a low melting point of 221°C in the eutectic composition (Sn-3.5 mass% Ag) and an alloy of tin and copper (SnCu alloy) has a low melting point of 227°C in the eutectic composition (Sn-1.7 mass% Cu) and both have advantages such as that the solder wettability, mounting strength, bendability, and reflowing property are excellent and that whiskers are not easily generated. The soluble salts (B) of metals nobler than tin may be used alone or a combination of two or more may be used. The content of the soluble salt (B) of a metal nobler than tin in the plating solution of the present embodiment is preferably in a range of 0.01 g/L or more and 10 g/L or less and more preferably in a range of 0.1 g/L or more and 2 g/L or less in terms of the amount of metal. In a case where the content of the soluble salt (B) of a metal nobler than tin is excessively low or excessively high, it is not possible for the composition of the solder alloy to be deposited to be a eutectic composition or to obtain the properties as a solder alloy.

[Tin Complexing Agent (C) formed of Sugar Alcohol having 4 or more and 6 or less Carbon Atoms]

In the tin alloy plating solution of the present embodiment, a tin complexing agent (C) formed of a sugar alcohol having 4 or more and 6 or less carbon atoms is used. Examples of tin complexing agents formed of a sugar alcohol having 4 carbon atoms include L-threitol, meso-erythritol, and the like. In addition, examples of tin complexing agents formed of a sugar alcohol having 5 carbon atoms include L-(-)-arabinitol, D-(+)-arabinitol, DL-arabinitol, ribitol, xylitol, and the like. Furthermore, examples of tin complexing agents formed of a sugar alcohol having 6 carbon atoms include D-iditol, L-iditol, L-sorbitol, D-sorbitol, L-mannitol, D-mannitol, galactitol, and the like.

The content of the tin complexing agent (C) formed of a sugar alcohol having 4 or more and 6 or less carbon atoms in the tin alloy plating solution of the present embodiment is 0.1 g/L or more and 5 g/L or less and preferably 1 g/L or more and 2.5 g/L or less. Here, in a case where the number of carbon atoms of the sugar alcohol is less than 4, interaction with the antioxidant does not occur in the presence of the free acid and the complex forming power with respect to the $Sn^{2+}$ is not sufficient to be able to suppress the generation of $SnO_2$ sludge, the metals nobler than tin are deposited by a substitution reaction, and the concentration of metals nobler than tin in the plating solution decreases. Also, in a case where the number of carbon atoms of the sugar alcohol is over 6, interaction with the antioxidant does not occur in the presence of the free acid and the complex forming power with respect to the $Sn^{2+}$ ions is not sufficient to be able to suppress the generation of $SnO_2$ sludge, the metals nobler than tin are deposited by a substitution reaction, the concentration of metals nobler than tin in the plating solution decreases, the effect of the additive (a brightening agent) is further reduced, and there are defects in the external appearance of the film after plating. In addition, the reason for limiting the content of the tin complexing agent (C) described above to within a range of 0.1 g/L or more and 5 g/L or less is that, when less than 0.1 g/L, there is a concern that it may not be possible to suppress the generation of $SnO_2$ sludge, the metal nobler than tin may be deposited by a substitution reaction, and the concentration of metals nobler than tin in the plating solution may decrease, while, when over 5 g/L, there is a concern that the effect of the additive (the brightening agent) may be reduced and there may be defects in the external appearance of the film after plating.

In addition, it is possible to use oxycarboxylic acids, polycarboxylic acids, and monocarboxylic acids as tin complexing agents other than the tin complexing agent formed of a sugar alcohol having 4 or more and 6 or less carbon atoms. Specific examples thereof include gluconic acid, citric acid, glucoheptonic acid, gluconolactone, acetic acid, propionic acid, butyric acid, ascorbic acid, oxalic acid, malonic acid, succinic acid, glycolic acid, malic acid, tartaric acid, salts thereof, and the like. Gluconic acid, citric acid, glucoheptonic acid, gluconolactone, glucoheptolactone, salts thereof, and the like are preferable. In addition, polyamines and aminocarboxylic acids such as ethylenediamine, 3,6-dithia-1,8-octanediol, ethylenediaminetetraacetic acid (EDTA), diethylenetriaminepentaacetic acid (DTPA), nitrilotriacetic acid (NTA), iminodiacetic acid (IDA), iminodipropionic acid (IDP), hydroxyethylethylenediaminetriacetic acid (HEDTA), triethylenetetraminehexaacetic acid (TTHA), ethylenedioxybis(ethylamine)-N,N,N',N'-tetraacetic acid, mercaptotriazoles, mercaptotetrazoles, glycines, nitrilotrimethylphosphonic acid, and 1-hydroxyethane-1,1-diphosphonic acid, or salts thereof are also useful as tin complexing agents.

Tin complexing agents other than the tin complexing agent formed of a sugar alcohol described above may be used alone or a combination of two or more may be used. The content of the complexing agent for tin other than the tin complexing agent formed of a sugar alcohol described above in the tin alloy plating solution of the present embodiment is generally preferably in a range of 0.1 g/L or more and 10 g/L or less and more preferably in a range of 0.5 g/L or more and 5 g/L or less.

<pH of Tin Alloy Plating Solution>

It is possible to apply the tin alloy plating solution of the present embodiment to tin alloy plating baths in the acidic pH range. In the field of bump formation using a Sn alloy plating solution, there is a demand for plating speeds at a current density of 2 ASD or higher from the viewpoint of productivity and, to ensure a plating speed of 2 ASD or higher, the pH of the plating solution is preferably 3 or less and more preferably less than 1. To adjust the pH of the tin alloy plating solution as described above, it is possible to include a pH adjuster. Examples of pH adjusters include various acids such as hydrochloric acid and sulfuric acid.

The lower limit value of the pH of the tin alloy plating solution may be 0.

[Free Acid (D)]

Examples of free acids (D) include hydrogen chloride, hydrogen bromide, sulfuric acid, alkane sulfonic acid, and aryl sulfonic acid or alkanol sulfonic acid. Specific examples of alkane sulfonic acid include methane sulfonic acid and ethane sulfonic acid. Specific examples of aryl sulfonic acids include benzene sulfonic acid, phenol sulfonic acid, and cresol sulfonic acid or toluene sulfonic acid. Specific examples of alkanol sulfonic acid include isethionic acid. The free acid (D) has the effect of increasing the conductivity of the tin alloy plating solution. In addition, the free acid (D) may be used alone or a combination of two or more may be used. The content of the free acid in the tin alloy plating solution of the present embodiment is preferably in a range of 5 g/L or more and 500 g/L or less and more preferably in a range of 30 g/L or more and 300 g/L or less.

[Antioxidant (E)]

The tin alloy plating solution of the present embodiment includes an antioxidant. Examples of antioxidants include ascorbic acid or salts thereof, pyrogallol, hydroquinone, phloroglucinol, trihydroxybenzene, catechol, cresol sulfonic acid or salts thereof, catechol sulfonic acid or salts thereof, hydroquinone sulfonic acid or salts thereof, and the like. For example, hydroquinone sulfonic acid or salts thereof are preferable in acidic baths, and ascorbic acid or salts thereof are preferable in neutral baths. In addition, the antioxidant may be used alone or a combination of two or more may be used. The content of the antioxidant in the tin alloy plating solution of the present embodiment is preferably in a range of 0.01 g/L or more and 20 g/L or less, more preferably in a range of 0.1 g/L or more and 10 g/L or less, and even more preferably in a range of 0.1 g/L or more and 5 g/L or less.

[Additive]

The tin alloy plating solution of the present embodiment may further include additives such as surfactants and brightening agents.

[Surfactant]

Surfactants have an action of increasing the affinity between the tin alloy plating solution and the object to be plated and an action of adsorbing onto the surface of the plating film during the formation of the tin alloy plating film to suppress crystal growth of the tin alloy in the plating film and to refine the crystals, thereby improving the external appearance of the plating film, improving adhesion to the object to be plated, achieving a uniform film thickness, and the like. It is possible to use various surfactants such as anionic surfactants, cationic surfactants, non-ionic surfactants, and amphoteric surfactants as surfactants.

Specific examples of anionic surfactants include alkyl sulfates, polyoxyethylene alkyl ether sulfates, polyoxyethylene alkyl phenyl ether sulfates, alkyl benzene sulfonates, alkyl naphthalene sulfonates, and the like. Specific examples of cationic surfactants include monoalkylamine salts, dialkylamine salts, trialkylamine salts, dimethyldialkyl ammonium salts, trimethylalkyl ammonium salts, and the like. Specific examples of non-ionic activators include non-ionic activators in which 2 moles or more and 300 moles or less of ethylene oxide (EO) and/or propylene oxide (PO) is addition-condensed with alkanols, phenols, naphthols and bisphenols having 1 or more and 20 or less carbon atoms, alkylphenols and arylalkylphenols having 1 or more and 25 or less carbon atoms, alkyl naphthols having 1 or more and 25 or less carbon atoms, alkoxyl phosphates (salts) having 1 or more and 25 or less carbon atoms, sorbitan esters, polyalkylene glycols, aliphatic amides having 1 or more and 22 or less carbon atoms, or the like. Specific examples of amphoteric surfactants include carboxy betaine, imidazoline betaine, aminocarboxylic acid, and the like.

One surfactant may be used alone or a combination of two or more may be used. The content of the surfactant in the tin alloy plating solution of the present embodiment is generally preferably in a range of 0.01 g/L or more and 50 g/L or less, more preferably in a range of 0.1 g/L or more and 20 g/L or less, and even more preferably in a range of 1 g/L or more and 10 g/L or less.

[Brightening Agent]

Brightening agents are added to form a uniform and dense plating film and to smooth the plating film. The brightening agent is formed of a first brightening agent and a second brightening agent, at least one of which is included. It is preferable to use two types, the first brightening agent and the second brightening agent, in order to improve the via filling properties and suppress void generation. Examples of the first brightening agent include one or two or more selected from the group consisting of aromatic carbonyl compounds, aliphatic aldehydes, aromatic aldehydes, aliphatic ketones, and aromatic ketones, while examples of the second brightening agent include $\alpha,\beta$-unsaturated carboxylic acids, amides thereof, or salts thereof.

The first brightening agent is a carbonyl compound including aldehydes and ketones, but not including the $\alpha,\beta$-unsaturated carboxylic acids of the second brightening agent. Aromatic carbonyl compounds are preferable as the first brightening agent. Aromatic carbonyl compounds have an action of refining the crystal particles of the tin alloy in the tin alloy plating film. Aromatic carbonyl compounds are compounds in which a carbonyl group (-CO-X: X means a hydrogen atom, a hydroxy group, an alkyl group having carbon atoms in a range of 1 or more and 6 or less, or an alkoxy group having carbon atoms in a range of 1 or more and 6 or less) is bonded to the carbon atom of the aromatic hydrocarbon. Aromatic hydrocarbons include benzene rings, naphthalene rings, and anthracene rings. Aromatic hydrocarbons may have substituents. Examples of substituents include halogen atoms, hydroxy groups, alkyl groups having carbon atoms in a range of 1 or more and 6 or less, or alkoxy groups having carbon atoms in a range of 1 or more and 6 or less. The carbonyl group may be directly linked to the aromatic hydrocarbon or may be bonded via an alkylene group having carbon atoms in a range of 1 or more and 6 or less. Specific examples of aromatic carbonyl compounds include benzalacetone, cinnamic acid, cinnamaldehyde, and benzaldehyde. Other examples of the first brightening agent include the following. Examples of aliphatic aldehydes include formaldehyde, acetaldehyde, allylaldehyde, and the like. In addition, examples of aromatic aldehydes include 2-chlorobenzaldehyde, 3-chlorobenzaldehyde, 4-chlorobenzaldehyde, 2,4-dichlorobenzaldehyde, 2,6-dichlorobenzaldehyde, 2,4,6-trichlorobenzaldehyde, 1-naphthaldehyde, 2-naphthaldehyde, 2-hydroxybenzaldehyde, 3-hydroxybenzaldehyde, 4-hydroxybenzaldehyde, 2-methylbenzaldehyde, 3-methylbenzaldehyde, 4-methylbenzaldehyde, m-anisaldehyde, o-anisaldehyde, p-anisaldehyde, and the like. In addition, examples of aliphatic ketones include acetylacetone and the like. Furthermore, examples of aromatic ketones include 2-chloroacetophenone, 3-chloroacetophenone, 4-chloroacetophenone, 2,4-dichloroacetophenone, 2,4,6-trichloroacetophenone, and the like. The above may be used alone or a combination of two or more may be used. The content of the first brightening agent in the tin alloy plating solution of the present embodiment (the amount alone when contained alone and the total amount when two or more types are contained) is preferably in a range of 0.01 mg/L or more and 500 mg/L or less, more preferably in a range of 0.1 mg/L or more and 100 mg/L or less, and even more preferably in a range of 1 mg/L or more and 50 mg/L or less. When the content of the component described above is low, there is a concern that the addition effect may not occur, whereas when the content of the component described above is excessively high, there is a concern that the smoothening of the plating film may be hindered.

Examples of the second brightening agent include acrylic acid, methacrylic acid, picolinic acid, crotonic acid, 3-chloroacrylic acid, 3,3-dimethylacrylic acid, 2,3-dimethylacrylic acid, methylacrylic acid, ethylacrylic acid, n-butyl acrylate, isobutyl acrylate, 2-ethylhexyl acrylate, ethyl methacrylate, n-butyl methacrylate, isobutyl methacrylate, 2-hydroxyethyl methacrylate, 2-hydroxypropyl methacrylate, 2-dimethylaminoethyl methacrylate, methacrylic acid anhydride, methyl methacrylate, and the like. In addition, the second brightening agent also includes amides of $\alpha,\beta$-unsaturated

carboxylic acids (for example, acrylamide) and salts of α,β-unsaturated carboxylic acids (for example, salts of potassium, sodium, ammonium, or the like). The content of the second brightening agent in the tin alloy plating solution of the present embodiment (the amount alone when contained alone and the total amount when two or more types are contained) is preferably 0.01 g/L or more and 50 g/L or less and more preferably 0.05 g/L or more and 10 g/L or less. When the content of the component described above is low, there is a concern that the addition effect may not occur, whereas when the content of the component described above is excessively high, there is a concern that the smoothening of the plating film may be hindered.

The tin alloy plating solution of the present embodiment includes (A) a soluble salt including at least a stannous salt, (B) a soluble salt of a metal nobler than tin, (C) a tin complexing agent formed of a sugar alcohol having 4 or more and 6 or less carbon atoms, (D) a free acid, and (E) an antioxidant, in which a content of the tin complexing agent is 0.1 g/L or more and 5 g/L or less and a concentration of divalent tin ions ($Sn^{2+}$) is 30 g/L or more, thus, the sugar alcohol having 4 or more and 6 or less carbon atoms acts together with the antioxidant in the presence of the free acid to make it possible to strongly stabilize the divalent tin ions ($Sn^{2+}$). As a result, $SnO_2$ sludge is not easily generated in the plating solution even when stored for a long period and it is possible to stabilize the concentration of Ag ions or Cu ions by suppressing a decrease in the concentration of Ag ions or Cu ions in the plating solution.

The tin alloy plating solution of the present embodiment is obtained by mixing (A) a soluble salt including at least a stannous salt, (B) a soluble salt of a metal nobler than tin, (C) a tin complexing agent formed of a sugar alcohol having 4 or more and 6 or less carbon atoms, (D) a free acid, (E) an antioxidant, other components (additives or the like), and water and carrying out preparation such that the content of the tin complexing agent is 0.1 g/L or more and 5 g/L or less and the concentration of divalent tin ions ($Sn^{2+}$) is 30 g/L or more. It is possible to use ion-exchanged water, distilled water, or the like as the water.

As a method for forming a plating film using the plating solution of the present embodiment, electroplating is used as described above. The current density during the formation of the plating film by electroplating is preferably in the range of 0.1 ASD or more and 100 ASD or less and more preferably in the range of 0.5 ASD or more and 20 ASD or less. The liquid temperature is preferably in the range of 10°C or higher and 50°C or lower and more preferably in the range of 20°C or higher and 40°C or lower.

[Examples]

Next, a detailed description will be given of Examples of the present invention together with Comparative Examples.

<Example 1>

Methane sulfonic acid as free acid, 3,6-dithia-1,8-octanediol and mercaptotetrazole as silver complexing agents, meso-erythritol as a sugar alcohol (a tin complexing agent), polyoxyethylene polyoxypropylene alkylamine (obtained by the addition and condensation of each of 25 moles of ethylene oxide (EO) and 30 moles of propylene oxide (PO) in alkylamine) as a surfactant, and benzalacetone as a brightening agent were mixed with an aqueous solution of tin methane sulfonate and dissolved and then a silver methane sulfonate solution was further added thereto and mixed. Finally, ion-exchanged water was added to prepare a bath of a SnAg plating solution (a tin alloy plating solution) having the following composition. The aqueous solution of tin methane sulfonate was prepared by electrolyzing a metal tin plate and an aqueous solution of silver methane sulfonate was prepared by electrolyzing a metal silver plate, in aqueous methane sulfonic acid solutions, respectively. Table 1 below shows the type of the metal nobler than tin, the type, intramolecular carbon number, and content ratio of the sugar alcohols, and the type and content ratio of the antioxidants, respectively.

(Composition of SnAg Plating Solution (Tin Alloy Plating Solution))

Tin methane sulfonate (as $Sn^{2+}$): 50 g/L
Silver methane sulfonate (as $Ag^+$): 0.5 g/L
Methane sulfonic acid (as a free acid): 100 g/L
3,6-dithia-1,8-octanediol (as a complexing agent for silver): 2 g/L
meso-erythritol (as a tin complexing agent (sugar alcohol)): 2 g/L
Mercaptotetrazole (as a complexing agent for tin): 1 g/L
Hydroquinone (as an antioxidant): 1 g/L
Polyoxyethylene polyoxypropylene alkylamine (as a surfactant): 5 g/L

Benzalacetone (as a brightening agent): 5 mg/L
Ion-exchanged water: balance
pH: less than 1

[Table 1]

| | Metal nobler than tin | Sugar alcohol | | | Antioxidant | |
| --- | --- | --- | --- | --- | --- | --- |
| | | Type | Intramolecular carbon number | Content ratio (g/L) | Type | Content ratio (g/L) |
| Example 1 | Ag | meso-erythritol | C4 | 2 | Hydroquinone | 1 |
| Example 2 | Ag | L-threitol | C4 | 2 | Hydroquinone | 1 |
| Example 3 | Ag | Ribitol | C5 | 2 | Hydroquinone | 1 |
| Example 4 | Ag | DL-arabinitol | C5 | 2 | Hydroquinone | 1 |
| Example 5 | Ag | Xylitol | C5 | 2 | Hydroquinone | 1 |
| Example 6 | Ag | L-iditol | C6 | 2 | Hydroquinone | 1 |
| Example 7 | Ag | Galactitol | C6 | 2 | Hydroquinone | 1 |
| Example 8 | Ag | D-sorbitol | C6 | 2 | Hydroquinone | 1 |
| Example 9 | Ag | D-mannitol | C6 | 2 | Hydroquinone | 1 |
| Example 10 | Ag | meso-erythritol | C4 | 0.1 | Hydroquinone | 1 |
| Example 11 | Ag | Xylitol | C5 | 5 | Hydroquinone | 1 |
| Example 12 | Ag | meso-erythritol | C5 | 1 | Hydroquinone | 1 |
| | Ag | D-sorbitol | C6 | 1 | | |
| Example 13 | Ag | D-sorbitol | C6 | 2 | Hydroquinone | 1 |
| Example 14 | Ag | Xylitol | C5 | 2 | Hydroquinone sulfonic acid | 1 |
| Example 15 | Cu | Xylitol | C5 | 5 | Hydroquinone | 1 |
| Comparative Example 1 | Ag | Glycerin | C3 | 2 | Hydroquinone | 1 |
| Comparative Example 2 | Ag | Volemitol | C7 | 2 | Hydroquinone | 1 |
| Comparative Example 3 | Ag | D-sorbitol | C6 | 0.01 | Hydroquinone | 1 |
| Comparative Example 4 | Ag | D-mannitol | C6 | 10 | Hydroquinone | 1 |
| Comparative Example 5 | Ag | Gluconic acid (not sugar alcohol) | C6 | 2 | Hydroquinone | 1 |
| Comparative Example 6 | Ag | None | - | 0 | Hydroquinone | 1 |
| Comparative Example 7 | Ag | None | - | 0 | Hydroquinone | 10 |
| Comparative Example 8 | Ag | None | - | 0 | Catechol sulfonic acid | 5 |

<Examples 2 to 12 and Comparative Examples 1 to 6>

As shown in Table 1, baths of SnAg plating solutions (tin alloy plating solutions) were prepared in the same manner as in Example 1, except that the type, intramolecular carbon number, and content ratio of the sugar alcohol were changed from Example 1.

<Example 13>

A bath of a SnAg plating solution (a tin alloy plating solution) was prepared in the same manner as in Example 8, except that the concentration of tin methane sulfonate (as $Sn^{2+}$) was changed to 30 g/L,

<Example 14>

As shown in Table 1, a bath of a SnAg plating solution (a tin alloy plating solution) was prepared in the same manner as in Example 5, except that the antioxidant was changed to hydroquinone sulfonic acid.

<Example 15>

As shown in Table 1, a bath of a SnCu plating solution (a tin alloy plating solution) was prepared in the same manner as in Example 11, except that the metal nobler than tin was changed to copper.

<Comparative Example 7>

As shown in Table 1, a bath of a SnAg plating solution (a tin alloy plating solution) was prepared in the same manner as in Example 1, except that no sugar alcohol was used and the type of antioxidant was the same as in Example 1 and only the concentration thereof was changed.

<Comparative Example 8>

As shown in Table 1, a bath of a SnAg plating solution (a tin alloy plating solution) was prepared in the same manner as in Example 1, except that no sugar alcohol was used and the type and concentration of the antioxidant were changed.

<Comparison Test>

The following tests (a), (b) and (c) were performed using the SnAg plating solutions (tin alloy plating solutions) or the SnCu plating solutions (tin alloy plating solutions) of Examples 1 to 15 and Comparative Examples 1 to 8.

(a) Residual percentage of Ag in SnAg plating solution or Cu in SnCu plating solution

The residual percentages of Ag or Cu in the plating solution when the SnAg plating solutions (tin alloy plating solutions) or SnCu plating solutions (tin alloy plating solutions) of Examples 1 to 15 and Comparative Examples 1 to 8 were stored for a predetermined period were determined as follows. First, the Ag concentration (g/L) or Cu concentration (g/L) in the plating solution initially (immediately after the bath) was measured using inductively coupled plasma optical emission spectroscopy (ICP-OES). This Ag concentration or Cu concentration was set as the "initial concentration". Next, the Ag concentration (g/L) or Cu concentration (g/L) in the SnAg plating solution was measured using ICP-OES after 1 L of the above-described SnAg plating solution or SnCu plating solution was placed in a washed polyethylene light-shielded container, tightly sealed, and stored statically for 6 months in an incubator manufactured by Panasonic set at 40°. The Ag concentration or Cu concentration was defined as the "concentration after storage". Furthermore, the residual percentage (%) of the Ag in the SnAg plating solution or the Cu in the SnCu plating solution was calculated using Formula (1).

Residual percentage (%) of Ag or Cu

= (post-storage concentration of Ag or Cu/initial concentration of Ag or Cu) x

100 (1)

The results are shown in Table 2 below. In Table 2, a plating solution in which the residual percentage of Ag or Cu in the plating solution was 80% or more was judged as "good" and a plating solution having less than 80% was judged as "bad".

(b) $Sn^{4+}$ concentration in SnAg plating solution or SnCu plating solution

The $Sn^{4+}$ concentration in the SnAg plating solutions (the tin alloy plating solution) or the SnCu plating solutions (the tin alloy plating solution) of Examples 1 to 15 and Comparative Examples 1 to 8 was determined as follows. First, the total Sn concentration in the plating solution was measured using inductively coupled plasma optical emission spectroscopy (ICP-OES). This Sn concentration was set as the "total Sn concentration". Next, the $Sn^{2+}$ concentration was measured in the above-described SnAg plating solution or SnCu plating solution by redox titration using iodine. This Sn concentration was set as the "$Sn^{2+}$ concentration". Furthermore, the $Sn^{4+}$ concentration (g/L) in the SnAg plating solution or the SnCu plating solution was calculated using Formula (2).

$$Sn^{4+} \text{ concentration (g/L)} = \text{total Sn concentration} - Sn^{2+} \text{ concentration (2)}$$

(c) Platability using SnAg plating solution or SnCu plating solution

The SnAg plating solution or SnCu plating solution of Examples 1 to 15 and Comparative Examples 1 to 8 were separately placed in a Hull Cell tank manufactured by Yamamoto-MS Co., Ltd., a copper Hull Cell plate was arranged as a cathode in the liquid, a platinum plate was arranged as an anode, and the platability of the plating solutions was evaluated by performing a Hull Cell test. As the plating conditions, the liquid temperature was set at 30°C, the current density was set to 4 ASD, and the plating process time was set to 10 minutes. During the plating process, the plating solution was stirred with a cathodic rocker. The results are shown in Table 1. The platability test was performed both initially (immediately after the bath) and after storage (static storage for 6 months at 40°C). In Table 1, the external appearance of the plating film was visually observed and a plating film with no abnormal depositions such as nodules and which was seen as bright was judged as "good". On the other hand, a plating film in which abnormal depositions such as nodules were seen or in which brightness was lost was judged as "bad".

[Table 2]

| | Metal nobler than tin | Ag or Cu in plating solution | | | | Sn⁴⁺ in plating solution | | Platability | | |
|---|---|---|---|---|---|---|---|---|---|---|
| | | Initial concentration (g/L) | Concentration after storage (g/L) | Residual percentage (%) | Evaluation | Initial concentration (g/L) | Concentration after storage (g/L) | Initial | After storage | Evaluation |
| Example 1 | Ag | 0.50 | 0.42 | 84 | Good | 0.0 | 3.2 | Good | Good | Good |
| Example 2 | Ag | 0.51 | 0.41 | 80 | Good | 0.3 | 3.5 | Good | Good | Good |
| Example 3 | Ag | 0.50 | 0.43 | 86 | Good | 0.2 | 2.8 | Good | Good | Good |
| Example 4 | Ag | 0.49 | 0.43 | 88 | Good | 0.1 | 2.7 | Good | Good | Good |
| Example 5 | Ag | 0.52 | 0.48 | 92 | Good | 0.3 | 1.4 | Good | Good | Good |
| Example 6 | Ag | 0.50 | 0.45 | 90 | Good | 0.5 | 1.8 | Good | Good | Good |
| Example 7 | Ag | 0.51 | 0.45 | 88 | Good | 0.2 | 3.1 | Good | Good | Good |
| Example 8 | Ag | 0.51 | 0.46 | 90 | Good | 0.4 | 1.6 | Good | Good | Good |
| Example 9 | Ag | 0.48 | 0.42 | 88 | Good | 0.8 | 2.7 | Good | Good | Good |
| Example 10 | Ag | 0.52 | 0.42 | 81 | Good | 0.6 | 4.5 | Good | Good | Good |
| Example 11 | Ag | 0.49 | 0.47 | 96 | Good | 0.2 | 0.9 | Good | Good | Good |
| Example 12 | Ag | 0.50 | 0.45 | 90 | Good | 0.2 | 1.7 | Good | Good | Good |
| Example 13 | Ag | 0.50 | 0.43 | 88 | Good | 0.3 | 1.5 | Good | Good | Good |
| Example 14 | Ag | 0.49 | 0.43 | 88 | Good | 0.4 | 2.1 | Good | Good | Good |
| Example 15 | Cu | 0.50 | 0.486 | 96 | Good | 0.1 | 4.3 | Good | Good | Good |
| Comparative Example 1 | Ag | 0.50 | 0.10 | 20 | Bad | 0.3 | 10.5 | Good | Bad | Bad |
| Comparative Example 2 | Ag | 0.50 | 0.32 | 64 | Bad | 0.2 | 7.6 | Bad | Bad | Bad |
| Comparative Example 3 | Ag | 0.51 | 0.20 | 39 | Bad | 0.1 | 9.8 | Good | Bad | Bad |
| Comparative Example 4 | Ag | 0.50 | 0.46 | 92 | Good | 0.5 | 2.0 | Bad | Bad | Bad |

| | Metal nobler than tin | Ag or Cu in plating solution | | | | Sn$^{4+}$ in plating solution | | Platability | | |
|---|---|---|---|---|---|---|---|---|---|---|
| | | Initial concentration (g/L) | Concentration after storage (g/L) | Residual percentage (%) | Evaluation | Initial concentration (g/L) | Concentration after storage (g/L) | Initial | After storage | Evaluation |
| Comparative Example 5 | Ag | 0.52 | 0.28 | 54 | Bad | 0.2 | 8.5 | Good | Bad | Bad |
| Comparative Example 6 | Ag | 0.50 | 0.05 | 10 | Bad | 0.2 | 12.5 | Good | Bad | Bad |
| Comparative Example 7 | Ag | 0.50 | 0.05 | 10 | Bad | 0.2 | 10.1 | Good | Bad | Bad |
| Comparative Example 8 | Ag | 0.50 | 0.05 | 10 | Bad | 0.2 | 10.4 | Good | Bad | Bad |

<Evaluation>

As is clear from Table 1 and Table 2, in the plating solution of Comparative Example 1, the sugar alcohol had an intramolecular carbon number of C3, which was less than the appropriate intramolecular carbon number (C4 or more and C6 or less) and thus the Ag residual percentage after static storage for 6 months at 40°C was as low as 20%, the Ag stability was inferior (bad), and the external appearance of the plating film deteriorated after the storage period and the Evaluation was bad.

In the plating solution of Comparative Example 2, the sugar alcohol had an intramolecular carbon number of C7, which was higher than the appropriate intramolecular carbon number (C4 or more and C6 or less) and thus the Ag residual percentage after static storage for 6 months at 40°C was as low as 64%, the Ag stability was inferior (bad), the action of the additive (the brightening agent) was also disturbed, and the external appearance of the plating film was bad both initially (immediately after the bath) and after storage and the Evaluation was bad.

In the plating solution of Comparative Example 3, the intramolecular carbon number of the sugar alcohol was C6, which is within the range of the appropriate molecular carbon number (C4 or more and C6 or less). However, the content was 0.01 g/L, which was less than the appropriate amount (0.1 g/L or more and 5 g/L or less). Therefore, the external appearance of the plating film was not a problem in the initial period (immediately after the bath), but, after a period of 6 months of static storage at 40°C, the concentration of Ag decreased and the external appearance of the plating film was judged to be bad.

In the plating solution of Comparative Example 4, the intramolecular carbon number of the sugar alcohol was C6, which was within the range of the appropriate molecular carbon number (C4 or more and C6 or less). However, the content was 10 g/L, which was higher than the appropriate amount (0.1 g/L or more and 5 g/L or less). Therefore, the Ag residual percentage was as high as 92% after static storage for 6 months at 40°C and there was no problem with the Ag stability (good), but the action of the additive (the brightening agent) was disturbed, the external appearance of the plating film was bad in the initial state (immediately after the bath), and the external appearance of the plating film was judged to be bad.

In the plating solution of Comparative Example 5, since gluconic acid, which is not a sugar alcohol, was used, the Ag residual percentage after static storage for 6 months at 40°C was as low as 54% and there was a problem with the Ag stability (bad), the external appearance of the plating film deteriorated after the above storage period and the Evaluation was bad.

In the plating solutions of Comparative Examples 6 to 8, since no sugar alcohol was added, regardless of the type or content ratio of the antioxidant, the Ag residual percentages after static storage for 6 months at 40°C were all as low as 10% and there was a problem with the Ag stability (bad), the external appearance of the plating film deteriorated after the above storage period, and the Evaluation was bad.

In contrast, in the plating solutions of Examples 1 to 15, the intramolecular carbon number of the sugar alcohol was within the range of an appropriate molecular carbon number (C4 or more and C6 or less) and the content thereof was 0.1 g/L or more and 5 g/L or less which was within the range of an appropriate amount (0.1 g/L or more and 5 g/L or less), thus, the Ag or Cu residual percentages after static storage for 6 months at 40°C were as high as 80% or more and 96% or less and there was no problem with the Ag or Cu stability (good), and the external appearance of the plating film had no abnormal depositions such as nodules from the initial period (immediately after the bath) to after the above storage period, was bright, and was judged to be good.

[Industrial Applicability]

It is possible to use the tin alloy plating solution of the present invention to form parts of electronic components such as bump electrodes of semiconductor wafers and printed substrates.

**Claims**

1. A tin alloy plating solution comprising:

   (A) a soluble salt or oxide including at least a stannous salt;
   (B) a soluble salt or oxide of a metal nobler than tin;
   (C) a tin complexing agent formed of a sugar alcohol having 4 or more and 6 or less carbon atoms;
   (D) a free acid; and
   (E) an antioxidant,

      wherein a content of the tin complexing agent is 0.1 g/L or more and 5 g/L or less, and

a concentration of divalent tin ions ($Sn^{2+}$) is 30 g/L or more.

2. The tin alloy plating solution according to claim 1,
   wherein the tin ally plating solution has a pH of 3 or less.

3. The tin alloy plating solution according to claim 1,
   wherein the metal nobler than tin is silver or copper.

4. The tin alloy plating solution according to claim 1,
   wherein a concentration of tetravalent tin ions ($Sn^{4+}$) is 5 g/L or less immediately after a plating bath or after storage for 6 months at 40°C in a light-shielded container under tightly sealed conditions.

## INTERNATIONAL SEARCH REPORT

| | International application No. |
|---|---|
| | **PCT/JP2021/045355** |

### A. CLASSIFICATION OF SUBJECT MATTER

***C25D 3/60***(2006.01)i
FI: C25D3/60

According to International Patent Classification (IPC) or to both national classification and IPC

### B. FIELDS SEARCHED

Minimum documentation searched (classification system followed by classification symbols)

C25D3/60

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2003-142088 A (DAIWA KASEI KENKYUSHO KK) 16 May 2003 (2003-05-16) examples 2, 13, paragraphs [0016]-[0017], [0030] | 1-4 |
| Y | | 1-4 |
| Y | JP 40-25483 B1 (OKUBO, Katsuhiro, UENO, Atsuyuki) 06 November 1965 (1965-11-06) examples 12, 9-10, page 1, left column, lines 19-24 | 1-4 |
| Y | JP 2-301588 A (C. UYEMURA & CO., LTD.) 13 December 1990 (1990-12-13) example 3, page 2, upper left column, line 18 to upper right column, line 2, page 2, lower right column, lines 2-4, 14-16 | 1-2, 4 |
| A | JP 2000-328286 A (YUKEN KOGYO KK) 28 November 2000 (2000-11-28) entire text | 1-4 |
| A | JP 64-42594 A (OSAKA CITY) 14 February 1989 (1989-02-14) entire text | 1-4 |
| A | JP 2016-524048 A (THE BOEING CO.) 12 August 2016 (2016-08-12) entire text | 1-4 |

☑ Further documents are listed in the continuation of Box C.  ☑ See patent family annex.

| | |
|---|---|
| \* Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **04 February 2022** | **15 February 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

International application No.

**PCT/JP2021/045355**

| C. | DOCUMENTS CONSIDERED TO BE RELEVANT | |
|---|---|---|
| Category* | Citation of document, with indication, where appropriate, of the relevant passages | Relevant to claim No. |
| A | JP 2017-190477 A (ELECTROPLATING ENG. OF JAPAN CO.) 19 October 2017 (2017-10-19)<br>entire text | 1-4 |

Form PCT/ISA/210 (second sheet) (January 2015)

**INTERNATIONAL SEARCH REPORT**
Information on patent family members

International application No.

**PCT/JP2021/045355**

| Patent document cited in search report | | | Publication date (day/month/year) | Patent family member(s) | | | Publication date (day/month/year) |
|---|---|---|---|---|---|---|---|
| JP | 2003-142088 | A | 16 May 2003 | (Family: none) | | | |
| JP | 40-25483 | B1 | 06 November 1965 | (Family: none) | | | |
| JP | 2-301588 | A | 13 December 1990 | (Family: none) | | | |
| JP | 2000-328286 | A | 28 November 2000 | (Family: none) | | | |
| JP | 64-42594 | A | 14 February 1989 | (Family: none) | | | |
| JP | 2016-524048 | A | 12 August 2016 | US entire text EP CN CN | 2015/0008131 3017092 105378151 108360029 | A1 A A A | |
| JP | 2017-190477 | A | 19 October 2017 | US entire text CN KR | 2017/0292200 107287629 10-2017-0116958 | A1 A A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021003148 A

- JP 6207655 B